# EUROPEAN PATENT SPECIFICATION

(11) **EP 0 819 887 B1**
(45) Date of publication and mention of the grant of the patent: **27.08.2003**
(21) Application number: 97304282.3
(22) Date of filing: 18.06.1997
(51) Int. Cl.: F23G 7/06

(54) **Combusting Exhaust Gas**
Abgasverbrennung
Combustion des fumées

(30) Priority: 19.06.1996 JP 15859996
(43) Date of publication of application: 21.01.1998
(73) Proprietor: The BOC Group plc, Windlesham Surrey GU20 6HJ (GB)
(72) Inventor: Takeuchi, Osamu, Ono-Shi, Hyogo 675 (JP); Nino, Sakae, Itami-Shi, Hyogo, 664 (JP)
(74) Representative: MacLean, Martin David

(56) References cited:
- EP-A- 0 262 561
- EP-A- 0 285 485
- EP-A- 0 735 321

## Description

The present invention relates to an apparatus for combusting an exhaust gas such as silane gas (which is discharged from a reaction furnace of a semi-conductor plant and the like) to form a harmless gas by oxidation, and to a method of operating said apparatus.

Exhaust gas such as silane gas which is discharged from a reaction furnace of semiconductor plants and the like is highly hazardous. Specifically, silane gas is inflammable when brought into contact with air. In order to prevent this silane, or other exhaust gas, is conventionally discharged as harmless gas from the combustion chamber by supplying air to the combustion chamber to combust the exhaust gas as the exhaust gas is discharged from the tip of a burner nozzle provided in the combustion chamber.

However, when silane gas is combusted, a great amount of silica (SiO₂) is produced. Silica exists as microscopic powder, which clogs the narrow bore of the nozzle thereby causing defective combustion in the case where a conventional burner nozzle is used.

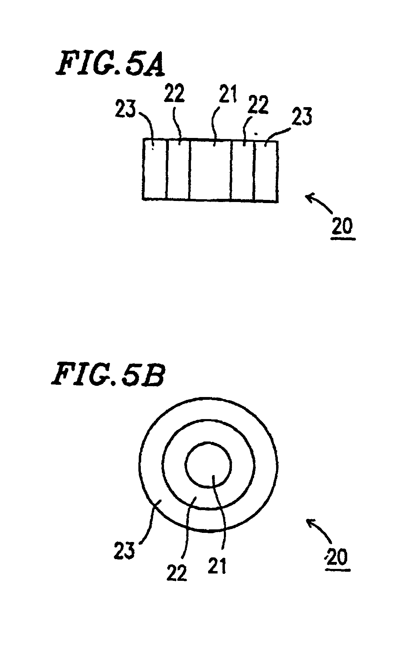

Conventionally, various technologies for preventing the clogging of the tip of the nozzle have been proposed, such as that illustrated in figures 5A and 5B, which show a nozzle 20 comprising three concentric tubes. The nozzle 20 includes a central silane gas introduction tube 21, a combustion gas ejection tube 22 surrounding the silane gas introduction tube 21, and an outermost mixture gas ejection tube 23 for ejecting a mixture gas including the combustion gas and air. Silane gas ejected from the silane gas introduction tube 21 is combusted by bringing the silane gas into contact with a flame which is generated by the mixture gas ejected from the mixture gas ejection tube 23. A combustion "curtain" of combustion gas ejected from the combustion gas ejection tube 22 is generated between the silane gas and the mixture gas. This combustion curtain prevents combustion of the silane gas in the vicinity of the tip of the silane gas introduction tube 21, and thus adhesion of silica to the tip of the nozzle is prevented. However, when a nozzle having such a structure is used, incomplete combustion may occur due to the small amount of air which is available for combustion; also, silane gas having a low concentration may not be removed.

A document showing the features of the preamble of claim 1 is represented by EP-A-0 285 485.

It is an object of the invention to address, and possibly eliminate, the above problems.

The invention therefore provides an apparatus with the characterizing features of claim 1 and a method with the features of claim 2.

The method may include the steps of introducing an exhaust gas through the exhaust gas nozzle at a flow velocity of 1 to 8 metres/second; forming a reducing flame by ejecting a first mixture gas obtained by mixing a fuel gas with air at a mixing ratio (by weight) of fuel gas:air of 1:3 to 1:10 through the first combustion nozzle at a flow velocity of 3 to 5 metres/second; and forming a substantially complete combustion flame by ejecting a second mixture gas obtained by mixing a fuel gas with air at a mixing ratio by weight of fuel:air of 1:14 to 1:16 through the second combustion nozzle at a flow velocity of 5 to 7 metres/second.

According to the present invention, an exhaust gas combustion nozzle has a four-layer structure. Due to a reducing flame curtain formed around an exhaust gas nozzle, combustion of a silane gas is suppressed in the vicinity of the exhaust gas nozzle. The silane gas is completely combusted at a location distant from the exhaust gas nozzle utilising the high temperature obtained from the reducing flame and combustion air supplied thereto. Thus, the silane gas can be completely combusted and removed regardless of the concentration of the silane gas. Since the silane gas is not combusted in the reducing combustion region, there occurs no adhesion of silica, which is a combustion product if a silane gas, onto the tip of the exhaust gas nozzle, the tips of second combustion nozzles (which are the nozzles for pilot gas) or the tip of a first combustion nozzle (which is a nozzle for main gas). The pilot gas is obtained by mixing fuel gas with a theoretical amount of air and is combusted to provide a complete combustion flame. Therefore, combustion of a pilot flame serving as an ignition source is stable throughout the operation. Thus, the apparatus can be operated safely.

Thus, the invention prevents the reduction in combustion efficiency due to the clogging of the tip of the nozzle, and also enables gas having a low concentration to be satisfactorily processed.

The invention will now be described by way of example and with reference to the accompanying drawings, in which:
Figure 1 is a cross-sectional view of an exhaust gas combustion nozzle in accordance with the present invention;
Figure 2A is a schematic cross sectional view of the exhaust gas combustion nozzle shown in Figure 1;
Figure 2B is a bottom view of the exhaust gas combustion nozzle shown in Figure 2A;
Figure 3 is a schematic view of an apparatus for combusting an exhaust gas in accordance with the present invention;
Figure 4 is a cross sectional view of a second embodiment of an exhaust gas combustion nozzle in accordance with the present invention;
Figure 5A is a schematic cross sectional view of a conventional exhaust gas combustion nozzle; and
Figure 5B is a bottom view of the conventional exhaust gas combustion nozzle shown in Figure 5A.

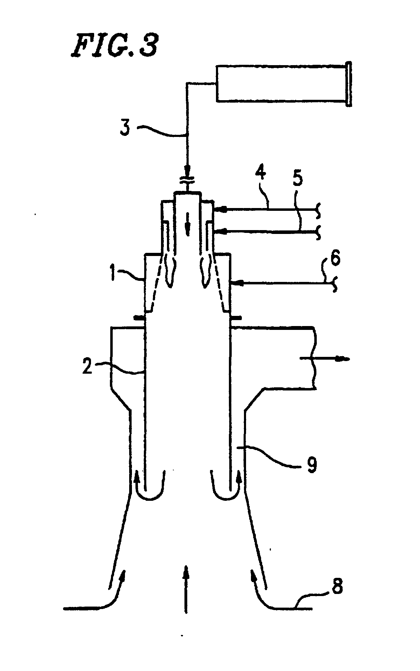

Figure 3 is a schematic view of an apparatus for combining exhaust gas according to the present invention. The apparatus includes a substantially cylindrical combustion chamber 2 and an exhaust gas combustion nozzle 1 provided above the combustion chamber 2. An exhaust gas introduction tube 3, a first mixture gas introduction tube 4, a second mixture gas introduction tube 5, and an air introduction tube 6 are connected to the exhaust gas combustion nozzle 1. The exhaust gas combusted in the exhaust gas combustion nozzle 1 is discharged below the combustion chamber 2 and is mixed with air 8 drawn in from outside the nozzle. The mixture gas, after being diluted, is sent outside the apparatus through a discharge path 9 by a blower (not shown). Products obtained by combustion, such as silica, are discharged through the discharge path 9 together with the air drawn in from outside.

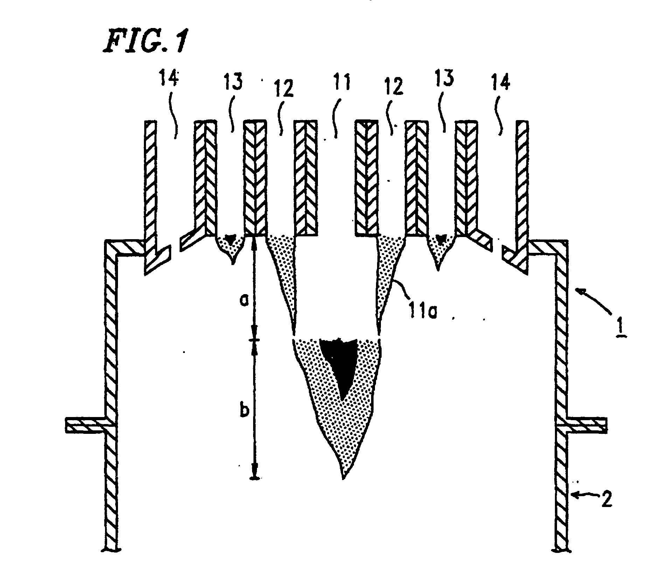

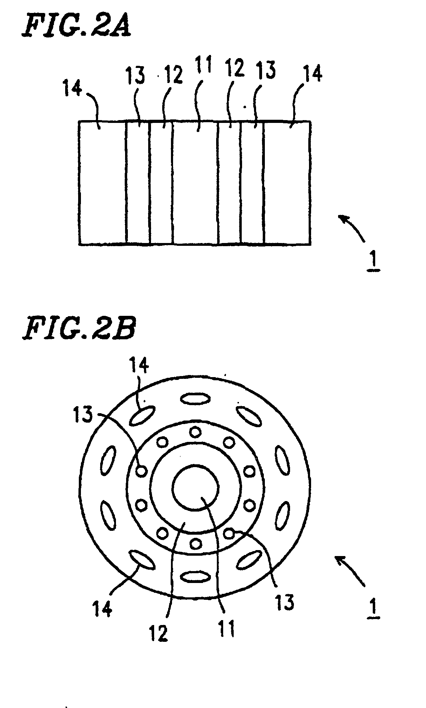

As shown in Figures 1, 2A and 2B, the exhaust gas combustion nozzle 1 includes an exhaust gas nozzle 11 provided at the centre thereof, an annular first combustion nozzle 12 is provided outside the exhaust gas nozzle 11, a second combustion nozzle 13 is provided outside first combustion nozzle 12, and an air supply nozzle 14 is provided outside the second combustion nozzle 13. The exhaust gas nozzle 11 is cylindrical and is connected to the exhaust gas introduction tube 3. Exhaust gas such as silane gas is introduced into the exhaust gas combustion nozzle 1 downward from the exhaust gas nozzle 11. The flow velocity of the exhaust gas introduced from the exhaust gas nozzle 11 is preferably 1 to 8 metres/second. By setting the flow velocity of the exhaust gas at a relatively high level, adhesion of the products obtained by combusting silane gas (such as silica) to the tip of the exhaust gas nozzle 11 can be effectively prevented.

The first combustion nozzle 12 is connected to the mixture gas introduction tube 4, and a first mixture gas is ejected from the first combination nozzle 12. A first combustion flame is generated by the first mixture gas ejected from the first combustion nozzle 12. The first combustion flame is obtained by substoichiometric, oxygen deficient, combustion. The first mixture gas is preferably in the ratio (by weight) of combustion gas and air of 1:5 to 1:10 (1:15 in the case of complete, stoichiometric, combustion). By such oxygen deficient combination, a reduction combustion area 11a is produced. The flow velocity of the first mixture gas is preferably 3 to 5 metres/second.

The second combustion nozzle 13 is formed of a plurality of small-diameter nozzles arranged in a ring around the first combustion nozzle 12 at an appropriate interval. The small-diameter nozzles can be, for example, circular or elliptical. The second combustion nozzle 13 is connected to the second mixture gas introduction tube 5. A second combustion flame ejected from the second combustion nozzle 13 is a so-called pilot flame. The second mixture gas is preferably in the ratio (by weight) of combustion gas and air of 1:14 to 1:16, so that complete combustion is realised to maintain safe operation of the apparatus. In order to maintain safe operation of the apparatus, the flow velocity of the second mixture gas is preferably 5 to 7 metre/second.

As shown in Figure 2B, the air supply nozzle 14 is formed as a plurality of nozzles arranged around the second combustion nozzle 13 at an appropriate interval. The nozzles can be, for example, circular, elliptical or rectangular. The air supply nozzle 14 is connected to the air introduction tube 6. A sufficient amount of air for combustion is supplied from the air supply nozzle 14 to realise complete combustion in the combustion range. In Figure 1, letter **a** indicates the reduction combustion area, and letter **b** indicates the complete combustion area.

The method and apparatus according to the present invention functions as follows:

Exhaust gas, such as silane gas, is introduced from the exhaust gas nozzle 11 provided in the exhaust gas combustion nozzle 1 and the oxygen deficient first combustion flame is ejected from the first combustion nozzle 1. The pilot flame is constantly combusted in the second combustion nozzle 13. Even when a sufficient amount of air is supplied from the air supply nozzle 14, the exhaust gas is not substantially combusted at the tip of the first combustion nozzle 12 since the combustion flame ejected from the first combustion nozzle 12 is a reducing flame as shown in Figure 1. Silica, which is obtained by combusting silane gas, does not clog the tip of the first and second combination nozzles 12 and 13. In the second combustion nozzle 13, a stable flame is maintained for safe operation by mixing the combustion gas with a theoretical amount of air. In other words, an accidental fire does not occur. A sufficient amount of air supplied from the air supply nozzle 14 allows the mixture gas and uncombusted gas from the first combustion nozzle 12 and the exhaust gas such as silane gas from the exhaust gas nozzle 11 to be completely combusted.

### Example

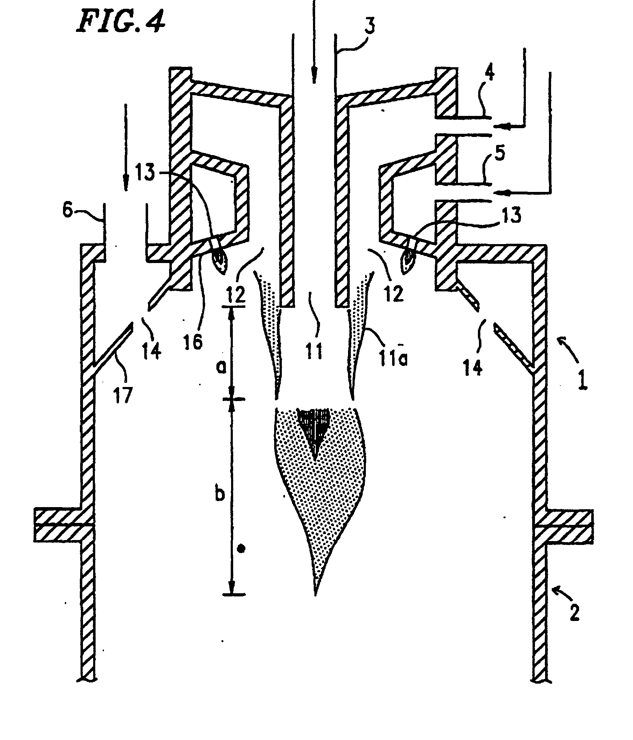

As shown in Figure 4, an exhaust gas combustion nozzle 1 includes an exhaust gas nozzle 11, an annular first combustion nozzle 12, a second combustion nozzle 13, and an air supply nozzle 14. The tip of the exhaust gas nozzle 11 projects downward from the tip of the first and second combustion nozzles 12 and 13. The second combustion nozzle 13 is formed by an opening in a slanted surface 16. The air supply nozzle 14 is formed by an opening in a slanted surface 17. The air supply nozzle 14 is substantially level with or positioned slightly below a tip area 11a of the exhaust gas nozzle 11.

Using the nozzle shown in Figure 4, silane gas having a concentration of about 0.5 to 100% was introduced into the exhaust gas combustion nozzle 1 from the exhaust gas nozzle 11 at a flow velocity of 1 to 8 metres/second. A first mixture gas (the mixture ratio by weight of the combination gas and air being about 1:10) was ejected from the first combustion nozzle 12 at a flow velocity of 3 metres/second, a second mixture gas (the mixture ratio by weight of the combustion gas and air being about 1:15) was ejected from the second combustion nozzle 13 at a flow velocity of 7 metres/second, and a sufficient amount of air was ejected from the air supply nozzle 14. Thus, silane gas was combusted. After combusting the silane gas for 15 days, no adhesion of silica to any of the nozzles was observed. The temperature of the combustion chamber was 250 to 400°C.

## Claims

1. An apparatus for combusting an exhaust gas, comprising an exhaust gas combustion nozzle (1) connected to a combustion chamber (2), wherein the exhaust gas combustion nozzle (1) includes an exhaust gas nozzle (11) provided at the centre of the exhaust gas combustion nozzle (1), an annular first combustion nozzle (12) provided so as to surround the exhaust gas nozzle (11), and an air supply nozzle or nozzles (14), wherein the first combustion nozzle (12) is capable of forming an oxygen deficient combustion region around the exhaust gas nozzle (11), **characterised in that** the exhaust gas combustion nozzle (1) additionally includes a plurality of second combustion nozzles (13) each having a small diameter arranged so as to surround the first combustion nozzle (12) and to be surrounded by the air supply nozzle or nozzles (14).

2. A method of operating the apparatus claimed in claim 1, wherein the exhaust gas is ejected through the exhaust gas nozzle (11), and air is ejected from the air supply nozzle or nozzles (14), **characterised in that** a reducing flame is ejected from the first combustion nozzle (12), a substantially complete combustion flame is ejected from the second combustion nozzles (13), an oxygen deficient combustion region (a) is formed by the reducing flame so as to surround the exhaust gas introduced into the combustion chamber (2) through the exhaust gas nozzle (11), and a sufficient amount of air is supplied from the air supply nozzle or nozzles (14) to realise complete combustion (b).

3. A method according to claim 2, comprising the steps of introducing the exhaust gas through the exhaust gas nozzle (11) at a flow velocity of 1 to 8 metres/second; forming the reducing flame by ejecting a first gas mixture obtained by mixing a fuel gas with air at a mixing ratio by weight of fuel gas to air of 1:3 to 1:10 through the first combustion nozzle (12) at a flow velocity of 3 to 5 metres/second, and forming a substantially complete combustion flame by ejecting a second gas mixture obtained by mixing a fuel gas with air at a mixing ratio by weight of fuel gas to air of 1:14 to 1:16 through the second combustion nozzles (13) at a flow velocity of 5 to 7 metres/second.

## Patentansprüche

1. Gerät zur Verbrennung eines Abgases, mit einer Abgasverbrennungsdüse (1), die mit einer Brennkammer (2) verbunden ist, wobei die Abgasverbrennungsdüse (1) eine Abgasdüse (11), die im Zentrum der Abgasverbrennungsdüse (1) vorgesehen ist, eine ringförmige erste Verbrennungsdüse (12), die die Abgasdüse (11) umgebend angeordnet ist, und eine Luftzufuhrdüse oder Luftzufuhrdüsen (14) aufweist, wobei die erste Verbrennungsdüse (12) zur Bildung eines Verbrennungsbereichs mit Sauerstoffmangel um die Abgasdüse (11) herum in der Lage ist, **dadurch gekennzeichnet, daß** die Abgasverbrennungsdüse (1) zusätzlich eine Mehrzahl zweiter Verbrennungsdüsen (13) aufweist, die jeweils einen kleinen Durchmesser haben und so angeordnet sind, daß sie die erste Verbrennungsdüse (12) umgeben und ihrerseits durch die Luftzufuhrdüse bzw. Luftzufuhrdüsen (14) umgeben sind.

2. Verfahren zum Betrieb des Geräts nach Anspruch 1, wobei das Abgas durch die Abgasdüse (11) ausgeblasen und Luft aus der Luftzufuhrdüse bzw. den Luftzufuhrdüsen (14) ausgeblasen wird, **dadurch gekennzeichnet, daß** eine reduzierende Flamme aus der ersten Verbrennungsdüse (12) ausgeblasen wird, eine Flamme mit im wesentlichen vollständiger Verbrennung aus den zweiten Verbrennungsdüsen (13) ausgeblasen wird, ein Verbrennungsbereich (a) mit Sauerstoffmangel durch die reduzierende Flamme gebildet wird, so daß dieser das durch die Abgasdüse (11) durch die Brennkammer (2) eingeleitete Abgas umschließt, und daß eine ausreichende Luftmenge aus der Luftzufuhrdüse bzw. den Luftzuführdüsen (14) zugeführt wird, um eine vollständige Verbrennung (b) zu bewerkstelligen.

3. Verfahren nach Anspruch 2, mit den Schritten des Einleitens des Abgases durch die Abgasdüse (11) mit einer Strömungsgeschwindigkeit von 1 bis 8 Meter/Sekunde, des Bildens der reduzierenden Flamme durch Ausblasen eines ersten Gasgemischs, das durch Mischen eines Brenngases mit Luft bei einem gewichtsmäßigen Mischungsverhältnis von Brenngas zu Luft von 1:3 bis 1:10 erhalten wird, durch die erste Verbrennungsdüse (12) mit einer Strömungsgeschwindigkeit von 3 bis 5 Meter/Sekunde, und des Bildens einer Flamme mit im wesentlichen vollständiger Verbrennung durch Ausblasen eines zweiten Gasgemischs, das durch Mischen eines Brenngases mit Luft bei einem gewichtsmäßigen Mischungsverhältnis von Brenngas zu Luft von 1:14 bis 1:16 durch die zweiten Verbrennungsdüsen (13) bei einer Strömungsgeschwindigkeit von 5 bis 7 Meter/Sekunde erhalten wird.

## Revendications

1. Dispositif pour la combustion d'un gaz d'échappement, comprenant une tuyère (1) de combustion d'un gaz d'échappement reliée à une chambre de combustion (2), dans lequel la tuyère (1) de combustion du gaz d'échappement comprend une buse (11) pour le gaz d'échappement prévue au centre de la tuyère (1) de combustion du gaz d'échappement, une première buse (12) de combustion annulaire prévue de manière à entourer la buse (11) pour le gaz d'échappement, et une buse ou des buses (14) pour l'alimentation en air, dans lequel la première buse (12) de combustion est apte à former une région de combustion déficiente en oxygène autour de la buse (11) pour le gaz d'échappement, ***caractérisé en ce que*** la tuyère (1) de combustion du gaz d'échappement comprend de plus une pluralité de secondes buses (13) de combustion ayant chacune un petit diamètre disposées de manière à entourer la première buse (12) de combustion et à être entourées par la buse ou les buses (14) d'alimentation en air.

2. Procédé d'utilisation du dispositif selon la revendication 1, dans lequel le gaz d'échappement est éjecté par la buse (11) pour le gaz d'échappement, et l'air est éjecté de la buse ou des buses (14) d'alimentation en air, ***caractérisé en ce qu*'**une flamme réductrice est éjectée de la première buse (12) de combustion, une flamme de combustion essentiellement complète est éjectée des secondes buses (13) de combustion, une région (a) de combustion déficiente en oxygène est formée par la flamme réductrice de manière à entourer le gaz d'échappement introduit dans la chambre de combustion (2) par la buse (11) pour le gaz d'échappement, et une quantité suffisante d'air est amenée par la buse ou les buses (14) d'alimentation en air pour réaliser la combustion complète (b).

3. Procédé selon la revendication 2, comprenant les étapes d'introduction du gaz d'échappement par la buse (11) pour le gaz d'échappement selon une vitesse d'écoulement de 1 à 8 mètres/seconde ; de formation de la flamme réductrice par éjection d'un premier mélange gazeux obtenu en mélangeant un gaz combustible avec de l'air selon un rapport pondéral de mélange du gaz combustible à l'air de 1/3 à 1/10 à travers la première buse (12) de combustion selon une vitesse d'écoulement de 3 à 5 mètres/seconde, et formation d'une flamme de combustion essentiellement complète par éjection d'un second mélange gazeux obtenu en mélangeant un gaz combustible avec de l'air selon un rapport pondéral de mélange du gaz combustible à l'air de 1/14 à 1/16 à travers les secondes buses (13) de combustion selon une vitesse d'écoulement de 5 à 7 mètres/seconde.
